Europäisches Patentamt

European Patent Office

Office européen des brevets

(19)

(11) Veröffentlichungsnummer: **0 036 671**
**A1**

(12) # EUROPÄISCHE PATENTANMELDUNG

(21) Anmeldenummer: **81102253.2**

(51) Int. Cl.³: **H 01 L 23/04, H 01 L 23/48**

(22) Anmeldetag: **25.03.81**

(30) Priorität: **26.03.80 DE 3011730**

(43) Veröffentlichungstag der Anmeldung: **30.09.81**
**Patentblatt 81/39**

(84) Benannte Vertragsstaaten: **BE DE FR GB IT**

(71) Anmelder: **SIEMENS AKTIENGESELLSCHAFT Berlin und München, Postfach 22 02 61, D-8000 München 22 (DE)**

(72) Erfinder: **Pilz, Dieter, Dipl.-Ing., Zugspitzstrasse 6, D-8039 Puchheim (DE)**

(54) **Gehäuse für elektrische Bauelemente, Bauelementegruppen oder integrierte Schaltungen.**

(57) Es wird ein Gehäuse für solche elektrischen Bauelemente, Bauelementegruppen oder integrierte Schaltungen vorgeschlagen, die nach aussen geführte, rechtwinklig abgebogene Anschlussteile aufweisen, das aus einem Schalenteil (1) und einem Deckelteil (12) besteht, wobei im Schalenteil (1) oder im Deckelteil (12) Ausnehmungen (5, 6) für die Anschlussteile (7, 8) vorhanden sind und ferner eine umlaufende Rinne (13) zwischen einem Steg (11) auf dem Deckel (12) und einem abgesetzten Teil (10) im Schalenteil (1) gebildet wird, in die die Vergussharzabdichtung gefüllt ist.

SIEMENS AKTIENGESELLSCHAFT
Berlin und München

Unser Zeichen
VPA

0036671

80 P 1 0 4 7 E

Gehäuse für elektrische Bauelemente, Bauelementegruppen
oder integrierte Schaltungen.

Die Erfindung betrifft ein Gehäuse für solche elektrischen Bauelemente, Bauelementegruppen oder integrierte Schaltungen, insbesondere für ein elektrisches Oberflächenwellenfilter, die durch das Gehäuse nach außen hindurchgeführte Anschlußteile für die mechanische und elektrische Verbindung mit einer gedruckten Schaltung aufweisen, das aus einem rechteckigen Schalenteil und einem darin angepaßten Deckelteil besteht und mittels Kunstharzverguß hermetisch dicht verschlossen ist.

Das Gehäuse gemäß der vorliegenden Erfindung eignet sich für passive und aktive elektrische Bauelemente (Widerstände, Kondensatoren, Induktivitäten, Relais, Dioden, Transistoren), Bauelementegruppen (auf einer Platine aufgetragene, miteinander verschaltete passive und/oder aktive elektrische Bauelemente), und für integrierte Schaltungen. Besonders vorteilhaft ist die Anwendung des Gehäuses für elektrische Oberflächenwellenfilter, die aus einem piezoelektrischen Körper mit darauf aufgebrachten, metallischen, die Oberflächenwellen erregenden (Eingangswandler), fortführenden (Koppler) und abnehmenden (Ausgangswandler) Belegungen besteht.

Integrierte Schaltungen, z.B. Operationsverstärker, sind in dem Buch der Firma Siemens: "Bauelemente, technische Erläuterungen und Kenndaten für Studierende", 2. Auflage, 1977, auf Seite 186 beschrieben.

Oberflächenwellenfilter der geschilderten Art sind in der Zeitschrift "Siemens Components" 18 (1980), Heft 1, Seiten 44 und 45 beschrieben, dort jedoch nur hinsichtlich

Bck 1 Lk / 24.3.1980

0036671

der Funktionen, nicht aber hinsichtlich der konstruktiven Details des Gehäuses.

Allen diesen elektrischen Bauelementen, Bauelementegruppen und integrierten Schaltungen ist gemeinsam, daß sie auf einen Träger aufgebracht sind, der in aller Regel aus einem Metallblech besteht und bereits die äußeren Anschlußteile aufweist, die durch das Gehäuse nach außen hindurchgeführt werden und die für die mechanische und elektrische Verbindung mit einer gedruckten Schaltung dienen, beispielsweise, indem dieser Träger durch ein Stanzverfahren hergestellt ist, sogenannte "Trägerspinne". Beim Zusammenbau werden die äußeren Anschlußteile entweder in einer Ebene mit dem Träger belassen oder insbesondere rechtwinklig abgebogen.

Integrierte Schaltungen und Halbleiterbauelemente dieser Art werden üblicherweise in Spritzformen mit einer Umhüllung versehen. Es kommt jedoch häufig vor, daß das elektrische Bauelement oder die integrierte Schaltung in einem Hohlraum des Gehäuses untergebracht sein muß, der mitunter sogar mit Innertgas gefüllt ist.

In der DE-OS 26 09 884 ist ein Wellenfilter mit elastischer Wellenausbreitungsfläche mit einem piezoelektrischen Substrat beschrieben, auf dessen einer Seite aus kammförmig ineinandergreifenden Teilen bestehende Umsetzelektroden angeordnet sind, von denen eine an eine elektrische Eingangssignalquelle und die andere an eine externe Last anschließbar ist, wobei die Umsetzelektroden mit räumlichen Abstand, jedoch durch das Substrat piezoelektrisch gekoppelt angeordnet sind und jede Umsetzelektrode zwei ineinandergreifende kammartige Elektrodenanordnungen aufweist. Dieses bekannte Filter ist in einem Gehäuse untergebracht, das aus einem Schalenteil und einem Deckelteil besteht. Die Anschlußteile für den äußeren Anschluß sind dabei entweder im Deckelteil fest angebracht oder um den Deckelteil herum geführt, während der Schalenteil über die Elektrodenanordnungen aufgebracht ist und der Deckelteil das Piezoelektrisch aktive Element darstellt. Der Schalenteil, dort als Schutzkappe bezeichnet, ist mit seiner Randfläche mit dem Randteil der die Elektroden tragenden Fläche des piezoelektrischen Substrates 10 verbunden, z.B. verklebt.

Die Montage dieses bekannten Wellenfilters ist aufwendig und schlecht automatisierbar, so daß die Herstellung großer Stückzahlen nicht gewährleistet ist. Es kommt hinzu, daß die Verbindung zwischen Schutzkappe und piezoelektrischem Substrat nicht frei von Durchlässen für atmosphärische Einflüsse (Feuchtigkeit, Abgase etc.) ist.

In der DE-AS 26 10 172 ist ein Filter auf der Basis der akustischen Oberflächenwellen beschrieben, bei welchem für das die Eingangs- und Ausgangswandler aufweisende piezoelektrische Substrat ein Gehäuse mit einer rechteckförmigen Bodenwand, einer rechteckförmigen Deckelwand und zwei Paaren einander gegenüberliegender Seitenwände vorgesehen ist und bei welchem sich das piezoelektrische Substrat im Inneren des Gehäuses im wesentlichen parallel zur Deckelwand und zur Bodenwand erstreckt, und bei welchem hinsichtlich der baulichen Ausbildung der Halterung für das Substrat davon ausgegangen ist, daß alle nutzbaren elektroakustischen Vorgänge, auf deren ungestörten Ablauf Bedacht zu nehmen ist, auf dem Substrat innerhalb der Wandler und auf der als Schalenübertragungsbahn dienenden Fläche zwischen den Wandlern vor sich gehen, wofür vorgeschlagen wird, daß im Inneren des Gehäuses dem Substrat zwei Abstützungen aus synthetischem oder natürlichem Kautschuk, vorzugsweise aus Silikon-Kautschuk, zugeordnet sind, von welchen die eine Abstützung am Substrat zwischen dem Eingangswandler

0036671

80 P 1047 E

und der diesem Wandler benachbarten Stirnwand des Substrats angeordnet ist, während die zweite Abstützung sich zwischen dem Ausgangswandler und der diesem Wandler benachbarten Stirnwand des Substrats befindet. Die nach außen führenden Anschlußstifte sind in der Bodenwand (Deckelteil) fest angeordnet. Der Deckelteil ist samt der piezoelektrischen Anordnung in den Schalenteil derart eingesetzt, daß ein Raum verbleibt. Nachdem das Filter in dieser Weise montiert ist, wird eine beträchtliche Schicht aus Kunstharz auf die Außenfläche des Deckelteils aufgetragen, um den Innenraum hermetisch abzudichten. Vor dem Aufbringen der Kunstharzschicht kann ein Innertgas in den Innenraum des Gehäuses eingeleitet werden.

Bei allen bekannten, in ein vorzugsweise aus Kunststoff bestehendes Gehäuse eingebauten elektrischen Bauelementen tritt die Schwierigkeit auf, daß das hermetische Abdichten nur unzureichend und auch nicht für lange Zeiträume dauerhaft durchgeführt werden kann. Die bei dem zuletzt beschriebenen bekannten Filter verwendete Kunstharzschicht schrumpft und erhält Risse, und zwar vollzieht sich dies schon in einem kurzen Zeitraum nach der Fertigstellung. Es kommt hinzu, daß die Montage des Gehäuses nicht oder nur schwierig automatisierbar ist.

Der vorliegenden Erfindung liegt die Aufgabe zugrunde, ein Gehäuse der einleitend angegebenen Art anzugeben, das eine automatisierbare Montage gewährleistet, indem das einzusetzende Bauelement, die Bauelementegruppe oder die integrierte Schaltung durch bestimmte Anordnungen in ihrer Lage festgelegt werden und indem dafür gesorgt wird, daß eine gewisse Abdichtung bereits ohne Kunstharzverguß eintritt, die beim weiteren Gang in der Fertigstellung das Eindringen des Kunstharzes in den Hohlraum in der Flüssigphase des Harzes verhindert.

0036671
80 P 1 0 4 7 E

Zur Lösung dieser Aufgabe ist das Gehäuse der einleitend angegebenen Art erfindungsgemäß dadurch gekennzeichnet, daß der Schalenteil in seinen einander gegenüberliegenden Seitenwänden Ausnehmungen, die den rechtwinklig abgebogenen Anschlußteilen des elektrischen Bauelements angepaßt sind, und ferner einen abgesetzten Teil aufweist, der zusammen mit einem Steg, der auf dem Deckelteil nach außen gerichtet vorhanden ist, eine umlaufende Rinne bildet, die mit der Vergußharzabdichtung gefüllt ist.

Eine entsprechende Lösung der der Erfindung zugrundeliegenden Aufgabe ist auch gegeben, wenn das Gehäuse der einleitend angegebenen Art erfindungsgemäß dadurch gekennzeichnet ist, daß der Deckelteil in seinen einander gegenüberliegenden Seiten Ausnehmungen, die den rechtwinklig abgebogenen Anschlußteilen des elektrischen Bauelements angepaßt sind, und ferner einen Steg aufweist, der zusammen mit einem abgesetzten Teil, der im Schalenteil vorhanden ist, eine umlaufende Rinne bildet, die mit der Vergußharzabdichtung gefüllt ist.

Die erste Lösungsart ist zu bevorzugen, weil durch das Anordnen von Ausnehmungen in den Seitenwänden des Schalenteils eine sehr genaue Zentrierung während der Herstellung möglich ist. Sind in Umkehrung dieser Ausführungsform die Ausnehmungen im Deckelteil angebracht, so ist zwar ebenfalls eine festgelegte Lage des elektrischen Bauelements möglich, jedoch kann es dabei erforderlich sein, während des automatischen Herstellungsprozesses das Bauelement um 180° in einer vertikalen Ebene zu drehen, damit der Verguß aus Kunstharz angebracht werden kann.

Anhand der beigefügten Figuren und der nachfolgenden Beschreibung wird die Erfindung näher erläutert.

0036671
80 P 1047 E

Es zeigen:

Fig. 1 das Gehäuse mit einem eingesetzten Oberflächenwellenfilter im zusammengebauten Zustand im Querschnitt;

Fig. 2 den Schalenteil im Querschnitt längs der Linie II, II in Fig. 3;

Fig. 3 den Schalenteil in Draufsicht entsprechend dem Pfeil A bei Fig. 2;

Fig. 4 den Schalenteil im Querschnitt längs der Linie IV, IV in Fig. 3;

Fig. 5 den Deckelteil im Querschnitt längs der Linie V, V in Fig. 6 und

Fig. 6 den Deckelteil in Draufsicht entsprechend dem Pfeil B bei Fig. 5.

In den Figuren sind für gleiche Teile gleiche Bezugszeichen verwendet.

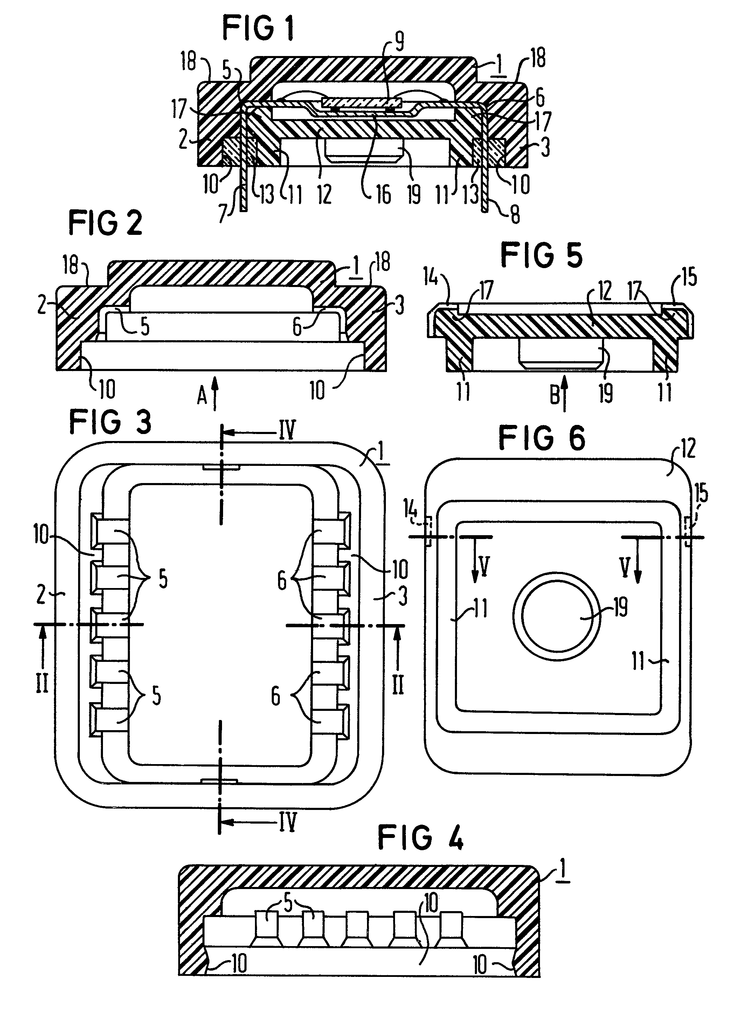

In Fig. 1 ist das zusammengebaute Gehäuse mit darin enthaltenem elektrischem Bauelment, hier einem Oberflächenwellenfilter, dargestellt. Der Deckelteil 1 umschließt das Bauelement 9, das auf einem Träger 16 montiert ist. Der Träger 16 geht in die rechtwinklig abgebogenen Anschlußteile 7 und 8 über. Diese Anschlußteile 7 und 8 sind in Ausnehmungen 2 und 3 des Deckelteils 1 eingelegt, die den Anschlußteilen angepaßt sind und in den Figuren 2 bis 4 näher gezeigt sind. Der Deckelteil 12 verschließt das Gehäuse und hält die Anschlußteile 7 und 8 in den Ausnehmungen 5 und 6 des Schalenteils 1. Der Schalenteil 1 weist in seinem Randbereich abgesetzte Teile 10 auf, die zusammen mit am Deckelteil 12 angebrachten Stegen 11 eine Rinne 13 bilden, die mit dem Vergußharz gefüllt ist.

Auf diese Weise ist ein genügend dichter Abschluß des Innenraums im Gehäuse bereits gewährleistet, der während des Vergießens des flüssigen Kunstharzes und seines anschließenden Auslötens haltbar ist, weil durch die Anpassung der Ausnehmungen 5 und 6 an die Anschlußteile 7 und 8 und durch den eingepaßten Deckelteil 12 die Abdichtung bereits sehr gut ist. Die in der Rinne 13 befindliche Vergußharzabdichtung braucht nur von geringer Menge zu sein, so daß Schrumpfungen kaum eintreten, jedenfalls Risse und Durchlässigkeiten sich nicht ergeben.

Der Deckelteil 12 gemäß Figur 5 wird nach Einsetzen des Bauelements in den Schalenteil 1 eingeschoben, wie aus den nebeneinander liegenden Figuren 2 und 5 bzw. 3 und 6 ersichtlich ist.

Der Deckelteil 12 weist Erhebungen 17 auf, die die Anschlußteile 7, 8 festhalten und auch zum Hohlraum im Gehäuse beitragen. Die Absetzungen 18 tragen dazu bei, daß die Materialstärke des Schalenteils 1 möglichst überall gleich ist, um die Schrumpfungen während des Herstellprozesses gleichmäßig zu halten. Der Zentrierknopf 18) dient zum Greifen und/oder Zentrieren des Deckelteils 12 während der automatischen Montage.

In den Figuren 5 und 6 ist gestrichelt angedeutet, daß die Ausnehmungen 14 und 15 zur Aufnahme der Anschlußteile 5 und 6 auch in den Erhebungen 17 im Deckelteil 12 angebracht sein können. In diesem Falle sind im Schalenteil keine Ausnehmungen vorhanden.

Das Gehäuse besteht aus den zwei angegebenen Kunststoffteilen, nämlich Schalenteil 1 und Deckelteil 2. Diese beiden Teile sind um die Trägerspinne, die aus dem Träger 16 und den daran befindlichen Anschlußteilen 5 und 6 besteht, herumgeführt. Das Anbringen des elektrischen Bauelements 9 kann auf der gestreckten Trägerspinne rationell erfolgen, die Anschlußteile 5 und 6 werden erst danach rechtwinklig nach unten abgebogen. Nach dem Zusammenfügen der beiden Teile des Gehäuses um die das Bauelement 9 tragende gebogene Trägerspinne entsteht aus dem abgesetzten Teil 10 im Schalenteil 1 und dem Steg 11 am Deckel 12 eine umlaufende Rinne, in deren Mitte die Anschlußteile 5, 6 heraustreten. Durch entsprechende Ausbildung des Schalenteils 1 oder des Deckelteils 12 wird bereits nach dem Zusammenfügen der Teile eine gewisse Abdichtung des Gehäuseinnenraumes erreicht, die das Eindringen von Gießharz verhindert. Dieses Harz wird in die Rinne 13 in Form von einem oder mehreren Tropfen eingeführt, verläuft entlang der Rinne, umschließt auch die Anschlußteile 5 und 6 und dichtet nach Aushärtung das Gehäuse weitgehend luftdicht ab. Vorzugsweise wird zum besseren Verlaufen des Harzes und zur schnelleren Härtung das Gehäuse vor dem Vergießen erwärmt und bis zur Aushärtung des Harzes auf dieser Temperatur gehalten.

Durch die vorliegende Erfindung wird erreicht, daß ein aus Kunststoff bestehendes Gehäuse vollautomatisch hergestellt und ebenfalls vollautomatisch mit dem elektrischen Bauteil versehen werden kann. Verklebungen oder thermoplastisches Verschweißen entfallen, so daß die dabei auftretende nachteilige thermische und mechanische Belastungen des elektrischen Bauelements während des Schweißvorgangs ausgeschlossen werden.

2 Patentansprüche
6 Figuren

Patentansprüche

1. Gehäuse für solche elektrischen Bauelemente, Bauelementegruppen oder integrierte Schaltungen, insbesondere für ein elektrisches Oberflächenwellenfilter, die durch das Gehäuse nach außen hindurchgeführte Anschlußteile für die mechanische und elektrische Verbindung mit einer gedruckten Schaltung aufweisen, das aus einem rechteckigen Schalenteil und einem darin angepaßten Deckelteil besteht und mittels Kunstharzverguß hermetisch dicht verschlossen ist, d a d u r c h   g e k e n n z e i c h - n e t, daß der Schalenteil (1) in seinen einander gegenüberliegenden Seitenwänden (2, 3) Ausnehmungen (5, 6), die den rechtwinklig abgebogenen Anschlußteilen (7, 8) des elektrischen Bauelements (9) angepaßt sind, und ferner einen abgesetzten Teil (10) aufweist, der zusammen mit einem Steg (11), der auf dem Deckelteil (12) nach außen gerichtet vorhanden ist, eine umlaufende Rinne bildet, die mit der Vergußharzabdichtung gefüllt ist.

2. Gehäuse für solche elektrischen Bauelemente, Bauelementegruppen oder integrierte Schaltungen, insbesondere für ein elektrisches Oberflächenwellenfilter, die durch das Gehäuse nach außen hindurchgeführte Anschlußteile für die mechanische und elektrische Verbindung mit einer gedruckten Schaltung aufweisen, das aus einem rechteckigen Schalenteil und einem darin eingepaßten Deckelteil besteht und mittels Kunstharzverguß hermetisch dicht verschlossen ist, d a d u r c h   g e k e n n z e i c h n e t, daß der Deckelteil (12) in seinen einander gegenüberliegenden Seiten Ausnehmungen (14, 15), die den rechtwinklig abgebogenen Anschlußteilen (7, 8) des elektrischen Bauelements (9) angepaßt sind, und ferner einen Steg (11) aufweist, der zusammen mit einem abgewetzten Teil (10), der im Schalenteil (1) vorhanden ist, eine umlaufende Rinne (13) bildet, die mit der Vergußharzabdichtung gefüllt ist.

**FIG 1**

**FIG 2**

**FIG 5**

**FIG 3**

**FIG 6**

**FIG 4**

| | Europäisches Patentamt | EUROPÄISCHER RECHERCHENBERICHT | 0036671<br>Nummer der Anmeldung<br>EP 81 10 2253.2 |

## EINSCHLÄGIGE DOKUMENTE

| Kategorie | Kennzeichnung des Dokuments mit Angabe, soweit erforderlich, der maßgeblichen Teile | betrifft Anspruch | KLASSIFIKATION DER ANMELDUNG (Int. Cl.³) |
|---|---|---|---|
| P | Patents Abstracts of Japan<br>Band 4, Nr. 52, 18. April 1980<br>Seite 21E7<br>& JP - A - 55 - 21154<br>-- | 1 | H 01 L 23/04<br>H 01 L 23/48 |
| | Patents Abstracts of Japan<br>Band 3, Nr. 149, 8. Dezember 1979<br>Seite 161E157<br>& JP - A - 54 - 129802<br>-- | 1 | |
| | Patents Abstracts of Japan<br>Band 3, Nr. 5, 18. Januar 1979<br>Seite 98E84<br>& JP - A - 53 - 132265<br>-- | 1,2 | **RECHERCHIERTE SACHGEBIETE (Int. Cl.³)**<br><br>H 01 L 23/02<br>H 01 L 23/48<br>H 03 H 9/10<br>H 05 K 5/00 |
| | IBM TECHNICAL DISCLOSURE BULLETIN<br>Band 22, Nr. 4, September 1979<br>New York<br>W.T. CHEN et al. "Module Cap with Heat Sink" -<br>* Seite 1427 *<br>-- | 1,2 | |
| | DE - U - 7 735 936 (SDS-ELEKTRO)<br>* Anspruch; Fig. 1 *<br>---- | 1 | **KATEGORIE DER GENANNTEN DOKUMENTE**<br><br>X: von besonderer Bedeutung<br>A: technologischer Hintergrund<br>O: nichtschriftliche Offenbarung<br>P: Zwischenliteratur<br>T: der Erfindung zugrunde liegende Theorien oder Grundsätze<br>E: kollidierende Anmeldung<br>D: in der Anmeldung angeführtes Dokument<br>L: aus andern Gründen angeführtes Dokument<br>&: Mitglied der gleichen Patentfamilie, übereinstimmendes Dokument |

| X | Der vorliegende Recherchenbericht wurde für alle Patentansprüche erstellt. | | |
|---|---|---|---|
| **Recherchenort**<br>Berlin | **Abschlußdatum der Recherche**<br>23-06-1981 | | **Prüfer**<br>ROTHER |

EPA form 1503.1   06.78